# EUROPÄISCHE PATENTANMELDUNG

(11) **EP 1 271 743 A2**
(43) Veröffentlichungstag der Anmeldung: **02.01.2003**
(21) Anmeldenummer: 02012846.8
(22) Anmeldetag: 10.06.2002
(51) Int. Cl.: H02J 7/00, H02M 3/158

(54) **Schaltungstopologie für einen bidirektionalen Energietransfer**

(30) Priorität: 19.06.2001 DE 10129353
(71) Anmelder: SIEMENS AKTIENGESELLSCHAFT, 80333 München (DE)
(72) Erfinder: Hebding, Uwe, 81249 München (DE); Krammes, Stefan, 47441 Moers (DE); Rudolph, Tom, 47506 Neukirchen-Vluyn (DE)

(57) **Zusammenfassung**

Schaltungstopologie für einen bidirektionalen Energietransfer, mit zwei Zuleitungen (2, 4), die jeweils einen MOSFET (6, 8, 20, 22) aufweisen, wobei die MOSFET (6, 8, 20, 22) mit ihren Gate- und ihren Source-Anschlüssen verbunden sind und ein Widerstand (10, 24) zwischen die verbundenen Gate-Anschlüsse und die verbundenen Source-Anschlüsse der MOSFET geschaltet sind, und wobei ein Fehlerverstärker (28) zur Erzeugung einer Steuerspannung für die Gate-Anschlüsse der MOSFET vorgesehen ist und
der Fehlerverstärker (28) zum Vergleich eines Istwertes einer jeweiligen Ausgangsspannung (U1, U2) der Schaltungstopologie mit einem Sollwert einer Referenzspannung (Uref) angeordnet ist.

## Beschreibung

Die vorliegende Erfindung bezieht sich auf eine Schaltungstopologie für einen bidirektionalen Energietransfer. Eine solche Schaltungstopologie ist aus der DE 195 48 612 A1 bekannt.

Es sind außerdem bereits Schaltungstopologien für einen bidirektionalen, ungeregelten Energietransfer bekannt. Die bisherigen Realisierungen sehen dabei jeweils einen Schaltungsblock für jede Transferrichtung vor, was eine doppelte Ausführung des Schaltungsblockes bedeutet. Die für jeden Schaltungsblock jeweils rückwärtige Richtung muss dabei in der Regel durch einen Schutzmechanismus gegen Verpolung geschützt werden.

Die Aufgabe der vorliegenden Erfindung ist es nun, eine Schaltungstopologie für einen bidirektionalen Energietransfer vorzusehen, durch die der bidirektionale Energietransfer regelbar wird, die möglichst wenige Bauteile aufweist und sich einfach und wirtschaftlich realisieren lässt.

Diese Aufgabe wird durch die Merkmale des unabhängigen Patentanspruches 1 gelöst, wobei zweckmäßige Ausführungsformen durch die Merkmale der Unteransprüche beschrieben sind.

Vorgesehen ist eine Schaltungstopologie für einen bidirektionalen Energietransfer, mit zwei Kanälen die jeweils einen MOSFET aufweisen, wobei die Schaltungstopologie dadurch gekennzeichnet ist, dass die MOSFET mit ihren jeweiligen Gateund Source-Anschlüssen verbunden sind, und die Steuerspannung über einen gemeinsamen Widerstand angelegt ist.

Diese auch mit "common source" bezeichnete Konfiguration hat gegenüber der auch als "common drain" bezeichneten sonst üblichen Verschaltung bidirektionaler Schalter den Vorteil, dass nur ein einziges Steuersignal für beide Transistoren erforderlich ist.

Beiden Konfigurationen gemeinsam ist allerdings, dass immer jeweils ein P-Kanal Transistor mit einer Spannung Uds < 0 im Vorwärtsbetrieb, der jeweils andere mit einer Spannung Uds > 0 im Reversbetrieb ist.

Die Schaltungstopologie nach Maßgabe der Erfindung zeichnet sich vorzugsweise weiterhin dadurch aus, dass ein Schalter zur Auswahl der Stromflussrichtung vorgesehen ist.

In der einen Schalterstellung fließt der Strom von der einen Spannung U1 zu der anderen Spannung U2, in der anderen Schalterstellung entsprechend umgekehrt. Durch diese Verbindung wird der Istwert der jeweiligen Ausgangsspannung mit einem Sollwert einer Referenzspannung Uref verglichen.

Die Schaltungstopologie zeichnet sich vorzugsweise auch dadurch aus, dass ein Fehlerverstärker vorgesehen ist, der zur Erzeugung eines entsprechenden Steuersignals dient, unabhängig von der Stellung des Schalters.

Schließlich kann die Schaltungstopologie auch durch Widerstands- und Kondensatorelemente zur Kompensation des Regelkreises ergänzt sein.

Durch die erfindungsgemäße Schaltung ist es möglich, einen bidirektionalen Energietransfer über ein aus 2 MOSFET bestehendes Stellglied vorzusehen, welches nicht nur schaltend, sondern auch analog betrieben werden kann.

Durch die Schaltungstopologie nach Maßgabe der Erfindung werden Anwendungen möglich, bei denen beispielsweise U2 von U1 gespeist werden kann (U₂=Ladegerät -> U₁: Akku).

Durch die Ansteuerung nach Maßgabe der vorliegenden Erfindung wird der Funktionsumfang der bekannten Schaltungstopologie derart erweitert, dass ein bidirektional regelbarer Energietransfer möglich ist, d.h. ein stufenlos einstellbarer bidirektionaler Energietransfer zwischen einer Energiequelle und einem Verbraucher oder einer zweiten Energiequelle. Als Konsequenz sind dann keine separaten Steckkontakte mehr erforderlich. Es genügt neben einem Masseanschluss ein einziger Kontakt.

Der Vorteil der Erfindung besteht somit unter anderem darin, dass sich die Anzahl der Bauteile und erforderlichen Steuersignale gegenüber den bekannten Schaltungstopologien für den bidirektionalen Energietransfer etwa halbiert, was eine Platz sparende und kostengünstige Implementierung in einem Gesamtsystem erleichtert.

Somit wird auf überraschend einfache Art und Weise durch eine schlichte regelungstechnische Ergänzung der Funktionsumfang einer bekannten Schaltungstopologie derart erweitert, dass nicht nur Komponenten und Material eingespart werden können, sondern auch neue Applikationen ermöglicht sind.

Die Erfindung kann in batteriebetriebenen Geräten eingesetzt werden, die eine Kontaktbuchse zum Laden besitzen. Die gleiche Buchse kann durch die Erfindung nun auch zur Versorgung von Verbrauchern benutzt werden, wie z.B. ein Mobiltelefon mit Ladebuchse über die auch ansteckbares Zubehör versorgt werden kann.

Weitere Eigenschaften und Vorteile der vorliegenden Erfindung ergeben sich aus der folgenden Beschreibung einer bevorzugten Ausführungsform, mit Bezug auf die beigefügten Zeichnungen; darin zeigt:
- Fig. 1: die schematische Darstellung einer SchaltungsTopologie für einen bidirektionalen Energietransfer,
- Fig. 2: die schematische Darstellung der Verwendung der Schaltungstopologie für einen bidirektionalen Energietransfer in einem Mobiltelefon.

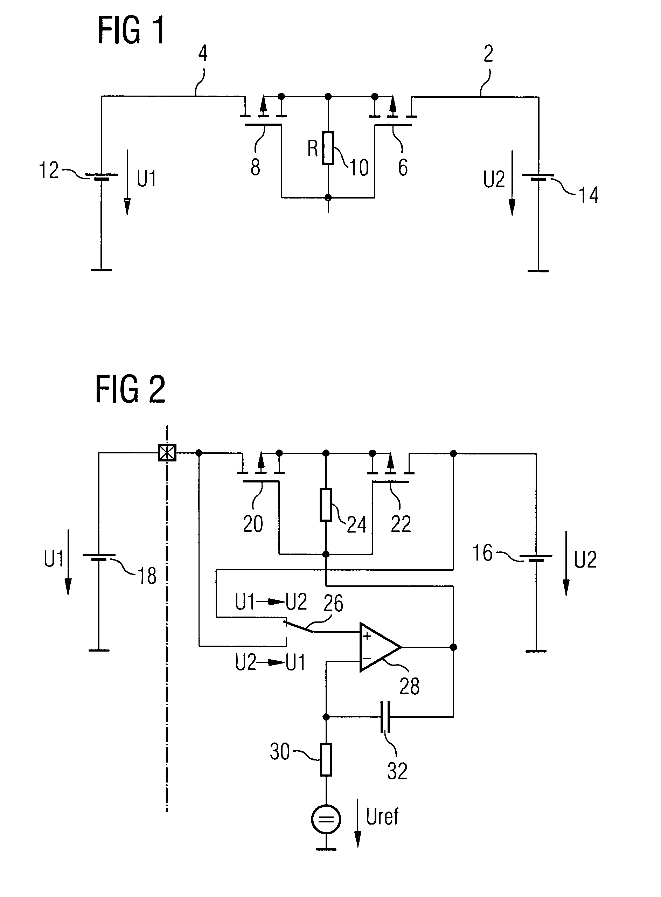

Die Fig. 1 zeigt die schematische Darstellung einer Schaltungstopologie für einen bidirektionalen Energietransfer. Vorgesehen sind dabei zwei Zuleitungen 2, 4 die jeweils einen MOSFET 6, 8 aufweisen. Wie der Fig. 1 zu entnehmen ist, sind die MOSFET 6, 8 mit ihren Gate- und Source-Anschlüssen verbunden. Die Steuerspannung ist dabei über einen beiden MOSFET 6, 8 gemeinsamen Widerstand 10 angelegt.

Erfolgt nun ein Energietransfer von einer ersten Energiequelle 12 zu einer zweiten Energiequelle 14, mit U1 > U2, so ist der eine MOSFET 6 im Vorwärtsbetrieb, während der andere MOSFET 8 im Reversbetrieb ist.

Erfolgt hingegen ein Energietransfer von der zweiten Energiequelle 14 zu der ersten Energiequelle 12, mit U2 > U1, so ist der eine MOSFET 6 im Reversbetrieb, während der andere MOSFET 8 im Vorwärtsbetrieb ist.

In der Fig. 2 ist die schematische Darstellung der Verwendung der Schaltungstopologie für einen bidirektionalen Energietransfer in einem Mobiltelefon gezeigt.

Der Bereich rechts der gestrichelten Linie bezeichnet dabei eine Mobiltelefonanordnung mit einer Spannungsquelle 16, bei der es sich im dargestellten Ausführungsbeispiel um eine Batterie oder einen Akkumulator handelt.

Der Bereich links der gestrichelten Linie bezeichnet mit einer eigenen Spannungsquelle 18 allgemein ein separates, ansteckbares Zubehör, was als Energiequelle oder -verbraucher dient, wie z.B. ein Ladegerät oder einen MP3-Player.

Die Schaltung nach Maßgabe der Fig. 2 weist zwei P-Kanal-MOSFET 20 und 22 auf. Die Gate- und Source-Anschlüsse des MOSFET 20 sind mit den entsprechenden Gate- und Source-Anschlüssen des MOSFET 22 verbunden, so dass die Steuerspannung über einen beiden MOSFET 20, 22 gemeinsamen Widerstand 24 angelegt werden kann. Diese Konfiguration (common source) hat gegenüber der sonst üblichen Verschaltung bidirektionaler Schalter (common drain) den Vorteil, dass nur ein einziges Steuersignal für beide Transistoren 20, 22 erforderlich ist. Beiden Konfigurationen gemeinsam ist jedoch, dass immer jeweils ein P-Kanal Transistor 20 mit einer Drain-Source-Spannung Uds < 0 im Vorwärtsbetrieb ist, der jeweils andere Transistor 22 mit einer Drain-Source-Spannung Uds > 0 im Reversbetrieb.

Weiterhin ist bei der Anordnung nach Fig. 2 ein Schalter 26 vorgesehen. Mit dem Schalter 26 kann ausgewählt werden, in welche Richtung der Stromfluss erfolgen soll.

In der in der Fig. 2 gezeigten oberen Schalterstellung "U1 -> U2" fließt der Strom von U1 nach U2, in der unteren Schalterstellung "U2 -> U1" entsprechend umgekehrt. Durch diese Verbindung wird der Istwert der jeweiligen Ausgangsspannung mit dem Sollwert der Referenzspannung Uref verglichen.

Weiterhin vorgesehen ist ein Fehlerverstärker 28, der unabhängig von der Stellung des Schalters 26 dann das entsprechende Steuersignal erzeugt. Die Spannungsversorgung des Fehlerverstärkers 28 ist in der Fig. 2 nicht mit eingezeichnet.

Schließlich sind bei der Anordnung wie in Fig. 2 dargestellt noch ein Widerstandselement 30 und ein Kondensatorelement 32 vorgesehen. Die Elemente 30 und 32 dienen der Kompensation des Regelkreises und sind insbesondere für den Analogbetrieb der Anordnung erforderlich.

Die Schaltung wie in Fig. 2 dargestellt dient dazu, einen bidirektionalen Energietransfer über ein einziges Stellglied zu ermöglichen, welches nicht nur schaltend, sondern auch analog betrieben werden kann. Bei der Anwendung des Mobiltelefons wie in Fig. 2 dargestellt, ist es durch die Erfindung möglich zum einen die Spannungsquelle 16 des Mobiltelefons zu laden, und zum anderen auch externe Verbraucher 18, wie ansteckbares Zubehör, MP3-Player, etc, zu speisen.

## Patentansprüche

1. Schaltungstopologie für einen bidirektionalen Energietransfer, mit zwei Zuleitungen (2, 4), die jeweils einen MOSFET (6, 8, 20, 22) aufweisen, wobei die MOSFET (6, 8, 20, 22) mit ihren Gate- und ihren Source-Anschlüssen verbunden sind und ein Widerstand (10, 24) zwischen die verbundenen Gate-Anschlüsse und die verbundenen Source-Anschlüsse der MOSFET geschaltet sind, und wobei ein Fehlerverstärker (28) zur Erzeugung einer Steuerspannung für die Gate-Anschlüsse der MOSFET vorgesehen ist und
der Fehlerverstärker (28) zum Vergleich eines Istwertes einer jeweiligen Ausgangsspannung (U1, U2) der Schaltungstopologie mit einem Sollwert einer Referenzspannung (Uref) angeordnet ist.

2. Schaltungstopologie nach Anspruch 1,
**dadurch gekennzeichnet,**
**dass** ein Schalter (26) zur Auswahl der Stromflussrichtung vorgesehen ist.

3. Schaltungstopologie nach einem der Ansprüche 1 bis 2,
**dadurch gekennzeichnet,**
**dass** sie in ein mobiles Telekommunikationsgerät integriert ist.
